# EUROPÄISCHE PATENTSCHRIFT

(11) **EP 0 654 176 B1**
(45) Veröffentlichungstag und Bekanntmachung des Hinweises auf die Patenterteilung: **20.05.1998**
(21) Anmeldenummer: 94911819.4
(22) Anmeldetag: 18.04.1994
(51) Int. Cl.: H01L 23/40

(54) **BEFESTIGUNGSVORRICHTUNG FÜR HALBLEITER-SCHALTELEMENTE**
SECURING DEVICE FOR SEMICONDUCTOR CIRCUIT COMPONENTS
DISPOSITIF DE FIXATION POUR ELEMENTS SEMI-CONDUCTEURS DE CIRCUIT

(30) Priorität: 07.06.1993 CH 1698/93
(43) Veröffentlichungstag der Anmeldung: 24.05.1995
(73) Patentinhaber: MELCHER AG, 8610 Uster (CH)
(72) Erfinder: BOSLI, Hans, Ludwig, CH-8603 Schwerzenbach (CH)
(74) Vertreter: Salgo, Reinhold Caspar, Dr.
(86) Internationale Anmeldenummer: CH9400076
(87) Internationale Veröffentlichungsnummer: WO9429901

(56) Entgegenhaltungen:
- DE-U- 8 510 248
- DE-U- 8 627 860
- FR-A- 2 419 659
- ELECTRONICS. Bd. 57, Nr. 4 , Februar 1984 , NEW YORK US Seiten 149 - 151 P. KIRBY 'Flexible Circuits Offer a Simple Solution to Chip-Carrier Mounting'
- IBM TECHNICAL DISCLOSURE BULLETIN. Bd. 27, Nr. 2 , Juli 1984 , NEW YORK US Seiten 1140 - 1142 E.F. JOY 'Moveable Transistor-to-Heat Sink Clamp'

## Beschreibung

Die vorliegende Erfindung bezieht sich auf eine Vorrichtung zum Befestigen von Halbleiter-Steuer- und -Schaltelementen, wie Transistoren, Thyristoren, Triacs u.ä., die zum Abführen der Verlustwärme ausgestaltet ist, nach dem Oberbegriff des Patentanspruches 1.

Eine derartige Vorrichtung ist bekannt, beispielsweise aus DE-U-85 10 248, die einen Kühlkörper mit einer Querplatte und senkrecht dazu stehenden Stegen und einen Federkörper mit davon ausgehenden Federzungen beschreibt, die jeweils ein elektronisches Bauelement gegen den Kühlkörper andrücken, wobei der Federkörper durch Verschrauben oder durch Einrasten in geeignete Löcher am Kühlkörper befestigt wird.

Weitere bekannte Vorrichtungen bestehen beispielsweise aus Kühlkörpern verschiedenster Ausgestaltung, auf denen die Halbleiter-Steuer- und Schaltelemente (fortan Halbleiter genannt) häufig mittels Schrauben befestigt sind, wozu viele solcher Halbleiter in ihrem Gehäuse selbst oder in einer daraus herausragenden Kühlfahne ein Befestigungsloch aufweisen.

Die bekannten Vorrichtungen weisen Eigenschaften auf, die sich als Nachteile auswirken, wenn die verfügbare Höhe der in aller Regel auf einer Leiterplatte montierten elektronischen Bauelemente beschränkt ist. Dies ist oft der Fall, da durch die weitgehende Normung von Baugruppen-Trägern, Steckerleisten und den zugehörigen Abständen in Elektronikgeräten die seitlichen Distanzen zwischen den Leiterplatten nur innerhalb eines festgelegten Rasters gewählt werden können. Ferner besteht der aus wirtschaftlichen Erwägungen fast zwingende Wunsch, die Leiterplatten so dicht nebeneinander anzuordnen, wie dies die Abführung der Verlustwärme gestattet.

Viele der bekannten Vorrichtungen sind hochbauend, was aus den genannten Gründen nachteilig ist. Ist vorgesehen, die Halbleiter mittels Schrauben am Kühlkörper zu befestigen, so sind je nach Potentiallage des Halbleitergehäuses, bzw. der Kühlfahne, zusätzliche Isolationsteile vorzusehen. Um den Wärmekontakt zwischen Halbleiter und Kühlkörper bei jeder Temperatur sicherzustellen, sind dabei zusätzlich elastische Elemente wie Federringe notwendig.

Es sind Befestigungsvorrichtungen bekannt, die als Federn ausgebildet sind. Diese erfüllen zwar einige Ansprüche hinsichtlich Einfachheit der Montage und Sicherstellung des Wärmekontaktes, sind aber in aller Regel nur für einen bestimmten Halbleiter-Gehäusetyp geeignet und ebenfalls hoch bauend und beanspruchen auf der Leiterplatte verhältnismässig viel Platz.

Die Aufgabe, die mit der vorliegenden Erfindung gelöst werden soll, ist die Schaffung einer Vorrichtung zum zuverlässigen Befestigen von Halbleitern mit dem erforderlichen Anpressdruck, die bei niedriger Bauhöhe guten Wärmekontakt zwischen Halbleiter und Kühlkörper bewirkt, für eine Vielzahl von Gehäusetypen einsetzbar ist und einfachste Montage gestattet unter Einhaltung aller notwendigen Isolationsanforderungen. Ferner soll der Fluss der zum Anpressen notwendigen Kraft die Leiterplatte nicht beanspruchen.

Die Lösung der gestellten Aufgabe ist wiedergegeben im kennzeichnenden Teil des Patentanspruches 1.

Anhand der beigegebenen Zeichnung wird die Erfindung näher erläutert. Es zeigen:
- Fig. 1a, b: ein erstes Ausführungsbeispiel in zwei Ansichten,
- Fig. 1c: ein Detail zum ersten Ausführungsbeispiel,
- Fig. 2: eine weitere Ausgestaltung eines erfindungsgemässen Kühlkörpers,
- Fig. 3: eine erste Variante zu Fig. 1a, b,
- Fig. 4a, b: eine zweite Variante zu Fig. 1a, b,
- Fig. 5: eine weitere Ausgestaltung der erfindungsgemässen Vorrichtung,
- Fig. 6: ein zweites Ausführungsbeispiel.

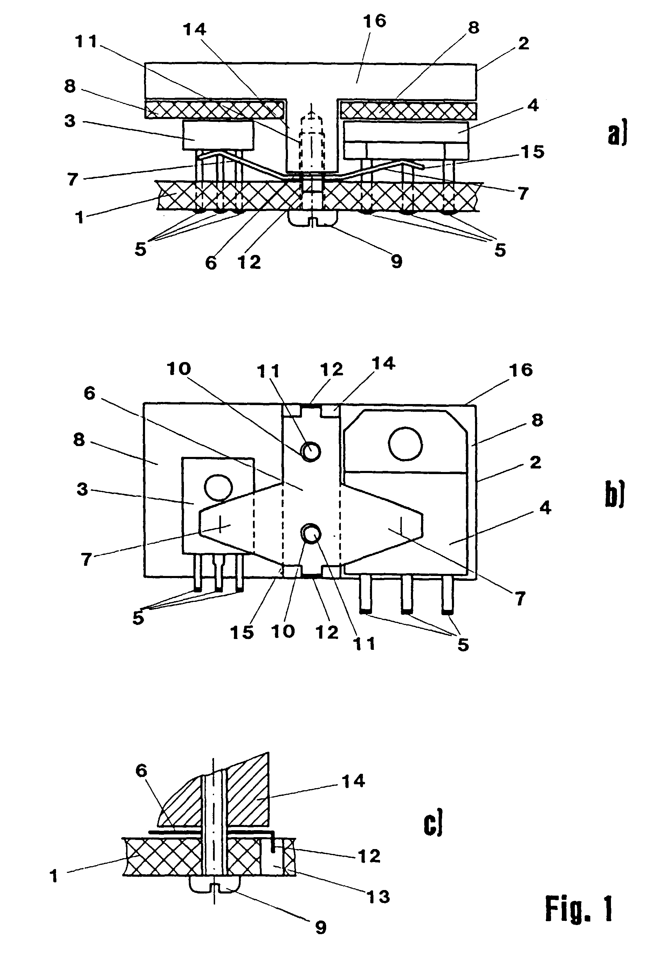

Fig 1a ist die Seitenansicht einer erfindungsgemässen Befestigungsvorrichtung in der Richtung der Ebene einer Leiterplatte 1 gesehen, welche im Schnitt dargestellt ist; Fig 1b zeigt die selbe Vorrichtung in Aufsicht von der Leiterplatte aus gesehen. Auf der Leiterplatte 1 ist mit zwei Schrauben 9 ein im Querschnitt etwa T-förmiger Kühlkörper 2 befestigt, welcher einen Steg 14 aufweist. Dazu trägt der Kühkörper 2 im Steg 14 zwei Gewindelöcher 11. Zwischen der Leiterplatte 1 und dem Steg 14 des Kühlkörpers 2 ist eine im wesentlichen rechteckige Grundplatte 6 eines Federkörpers 15 eingelegt. Diese Grundplatte 6 weist zwei Löcher 10 auf, die mit den Gewindelöchern 11 fluchten. Wird der Kühlkörper 2 dann mit den Schrauben 9 an der Leiterplatte 1 festgezogen, so ist damit auch die Grundplatte 6 befestigt. An den beiden Schmalseiten weist die Grundplatte 6 je eine gegen die Leiterplatte 1 abgewinkelte Fahne 12 auf. In Fig. 1c ist deutlich, dass die Fahnen 12 in je ein Loch 13 in der Leiterplatte 1 hineinragen. Mit Hilfe dieser Löcher 13 wird der Federkörper 15 genau positioniert.

Die Grundplatte 6 des Federkörpers 15 weist ferner zwei seitliche Federzungen 7 auf, die durch ihre Biegung und Vorspannung in der Lage sind, je einen Halbleiter 3, 4 gegen den Kühlkörper 2 zu drücken. Zum Zwecke der Isolation ist zwischen die Halbleiter 3, 4 und den Kühlkörper 2 je ein isolierendes Teil, beispielsweise ein Plättchen 8 aus Aluminiumoxid oder eine elektrisch isolierende aber gut wärmeleitende Folie, eingelegt. Fig. 1b zeigt die Situation von der Leiterplatte 1 aus - bezüglich der Darstellung von Fig. 1a - nach oben gesehen; Fig. 1c ist ein Detail, wiederum im Schnitt, in bezug auf Fig. 1avon links gesehen. Mit der Ziffer 5 sind die elektrischen Anschlüsse der Halbleiter 3, 4 bezeichnet. In Fig. 1a, b, c sind zwei sehr verschieden grosse Halbleiter dargestellt, beispielsweise die Gehäusetypen T0 126 und T0 218. Die hier dargestellte Form des Külkörpers 2 hat den Vorteil, dass die Wärme von den Halbleitern 3, 4 breitflächig über eine kurze Ableitstrekke direkt auf den Kühlkörper 2, bzw. dessen Querplatte 16 abströmt, ohne den Steg 14 - und damit die Leiterplatte 1 - zu belasten. Die Wärme wird dann ebenfalls breitflächig von der ganzen Fläche der Querplatte 16 abgegeben.

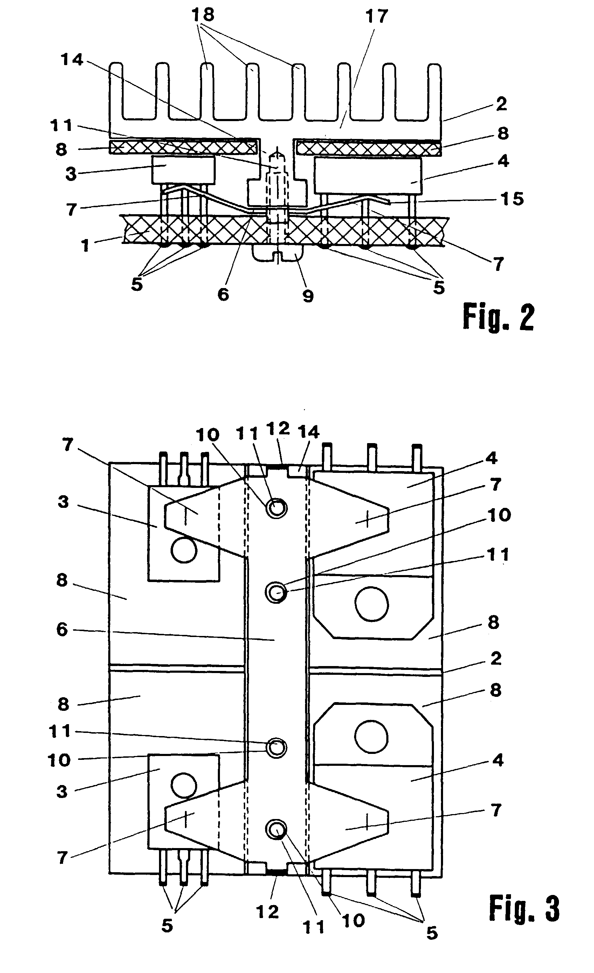

Fig. 2 zeigt eine zweite Ausgestaltung des Kühlkörpers 2. Anstelle der eben ausgebildeten Querplatte 16 aus Fig. 1a tritt eine Rippenplatte 17 mit einer Mehrzahl von Kühlrippen 18. Diese Ausführungsform des Kühlkörpers 2 ist günstig vor allem für Halbleiter auf freistehenden Leiterplatten, während die Ausführungsform gemäss Fig. 1a sich vor allem dort anbietet, wo die Leiterplatte 1 mit den darauf befindlichen Schaltelementen zusätzlich in ein Gehäuse eingebaut wird, oder eine Abdeck- oder Wärmeableitplatte auf mehrere erfindungsgemässe Kühlkörper montiert wird. Dann kann die eben ausgebildete Querplatte 16 in Wärmekontakt mit dem genannten Gehäuse oder der Abdeckplatte treten, wodurch wirksame Wärmeabfuhr an die Umgebungsluft ermöglicht wird.

Die Darstellung des Ausführungsbeispiels gemäss Fig. 3 entspricht jener von Fig. 1b. Hier ist der Kühlkörper 2 so gross ausgeführt, dass vier Halbleiter 3, 4 darauf Platz finden. Dieser Vergrösserung gegenüber dem ersten Ausführungsbeispiel entsprechend weist der Federkörper 1S vier Federzungen 7 auf, von welchen jede einen Halbleiter 3, 4 gegen ein isolierendes Plättchen 8 und damit gegen die Unterseite der Querplatte 16 oder der Rippenplatte 17 drückt. Selbstverständlich sind die gezeichneten Halbleiter 3, 4 nur beispielsweise zu verstehen; alle im wesentlichen eben ausgeführten Halbleiter können an deren Stelle treten. Ebenso hat die Anzahl der elektrischen Anschlüsse 5 keine erfindungswesentliche Bedeutung. Entsprechend der Verlängerung der Grundplatte 6 wird die Anzahl der Löcher 10 auf vier erhöht. Auch diese Zahl ist nur als Beispiel zu verstehen; die Ausdehnungen der Befestigungsvorrichtung können fünf Löcher notwendig machen oder auch nur deren zwei genügend erscheinen lassen.

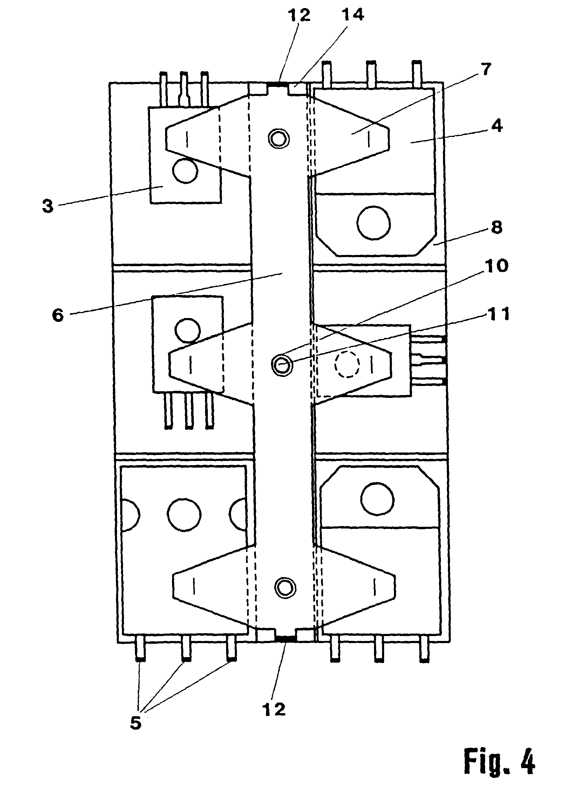

Fig. 4 ist die Darstellung einer weiteren Variante zu Fig. 1: Hier sind sechs Halbleiter auf den gleichen - entsprechend verlängerten - Kühlkörper 2 montiert. Entsprechend ist auch die Zahl der Federzungen 7 am Federkörper 15 auf sechs erhöht. Die übrigen Ausführungsmerkmale bleiben dieselben, wie in Fig 3.

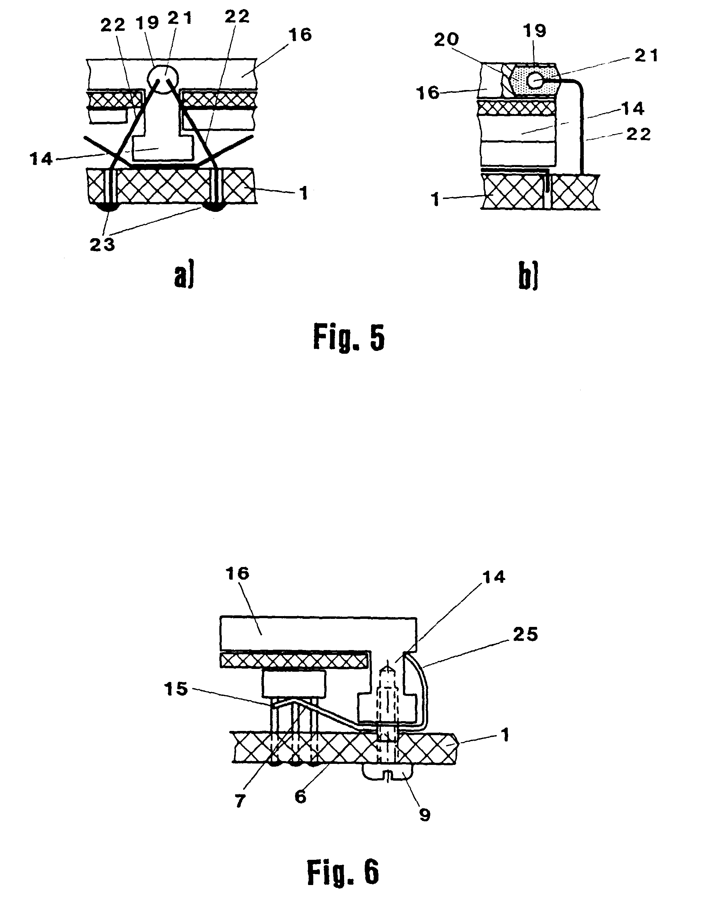

Fig. 5a, b zeigen eine weitere erfindungsgemässe Ausbildung der Befestigungsvorrichung. In zwei Detailansichten, welche den Darstellungen von Fig. 1a, c entsprechen, weist die Querplatte 16 über dem Steg 14 eine Sackbohrung 19 auf. In diese ist - beispielsweise mittels einer einen guten Wärmekontakt ermöglichenden Vergussmasse 20 - ein Temperaturfühler 21 eingelassen, welcher mittels elektrischer Leiter 22 an entsprechenden Kontakten 23 der Leiterplatte 1 angelötet ist. Damit kann die Temperatur des Kühlkörpers 2 dauernd elektrisch überwacht werden. Selbstverständlich kann an die Stelle einer Querplatte 16 auch eine Rippenplatte 17 gemäss Fig. 2 treten; ebenso ist es möglich, an jedem Ende einer Querplatte 16 oder Rippenplatte 17 einen solchen Temperaturfühler 21 vorzusehen, besonders wenn diese genannten Teile die Ausdehnungen gemäss Fig. 3 aufweisen. Dies ermöglicht die Ueberwachung von allenfalls ungleichen Verlustleistungen von Halbleitern 3, 4.

Die Ausführung des Steges 14 ist in Fig 5.a, b leicht von derjenigen in Fig. 1 verschieden: Er ist gegen die Leiterplatte hin fussartig verbreitert, bzw. gegen die Querplatte 16 oder die Rippenplatte 17 hin schlanker ausgeführt. Damit wird die seitliche Isolationsstrecke der Halbleiter 3, 4 zum Steg 14 vergrössert, ferner kann der Wärmestrom zur Leiterplatte 1 hin verkleinert werden.

Der Abstand der Querplatte 16 von der Leiterplatte 1 kann unterschiedlich gestaltet werden entweder durch verschieden hohe Stege 14, oder durch Einlegen von (nicht gezeichneten) Distanzstücken zwischen Leiterplatte 1 und Fuss des Steges 14. Damit kann der Raum zwischen den Halbleitern 3, 4 und der Leiterplatte 1 uneingeschränkt für Leiterbahnen und, bei genügendem Abstand, auch für elektronische Bauelemente genutzt werden.

In Fig. 6 ist ein weiteres Ausführungsbeispiel der erfindungsgemässen Befestigungsvorrichtung dargestellt. Hier ist der Kühlkörper 2 nicht T-förmig, sondern nur einseitig ausgeführt. Diese einseitige Ausführung kann dennoch Platz für mehrere Halbleiter aufweisen. Um die Leiterplatte 1 vom Kraftfluss der Anpresskräfte zu befreien, ist der Federkörper 15 auf der der Federzunge 7 abgewandten Seite mit einem Federsporn 25 versehen, welcher an der Stelle angreift, wo der Steg 14 in die Querplatte 16 mündet. Damit kann bewirkt werden, dass die Federzunge 7 die gleiche Federcharakteristik aufweist, wie in den vorgenannten Ausführungsbeispielen.

Die Ausführung der Federzunge 7 als im wesentlichen trapezförmig ist nicht an sich erfindungswesentlich; Federzungen 7 mit anderer Form und Durchbiegungscharakteristik sind im Erfindungsgedanken ebenfalls mitenthalten. Ebenso kann der Teil der Federzunge 7, welcher auf den Halbleiter 3, 4 drückt, anders ausgestaltet sein, beispielsweise so, dass die Kraft flächig verteilt, anstatt linienförmig auf den zu befestigenden Halbleiter 3, 4 wirkt.

## Patentansprüche

1. Auf einer Leiterplatte (1) angebrachte Vorrichtung zum Befestigen von Halbleiter-Steuer- und -Schaltelementen fortan: Halbleiter (3, 4) und zum Abführen von deren Verlustwärme, welche Vorrichtung besteht einerseits aus einem Kühlkörper (2), andererseits aus einem Federkörper (15) zum Andrücken der Halbleiter (3, 4) an den Kühlkörper (2), wobei der Kühlkörper gegliedert ist in einen senkrecht auf der Leiterplatte (1) stehenden Steg (14), welcher eine senkrecht zu ihm, also parallel zur Leiterplatte (1), verlaufende Querplatte (16) trägt, und der Federkörper (15) gegliedert ist in eine Grundplatte (6) und davon ausgehende Federzungen (7), dadurch gekennzeichnet, dass
- der Steg (14) des Kühlkörpers (2) Gewindelöcher (11) trägt zur Aufnahme von Schrauben (9), mit welchen der Steg (14) auf der Leiterplatte (1) befestigt wird,
- die Grundplatte (6) des Federkörpers (15) zwischen die Leiterplatte (1) und den Steg (14) eingelegt und mit den genannten Schrauben (9) festgezogen ist, wozu die Grundplatte (6) mit den Gewindelöchern (11) fluchtende Löcher (10) aufweist,
- die Federzungen (7) so geformt und vorgespannt sind, dass sie gegen die leiterplattenseitige Fläche der Querplatte (16) drücken,
- die leiterplattenseitige Fläche der Querplatte (16) eben ausgebildet und so dimensioniert ist, dass ein Halbleiter (4) mit dem Gehäusetyp TO 247 ohne Ueberstand zwischen die leiterplattenseitige Fläche der Querplatte (16) und die Federzunge (7) eingelegt werden kann,
- ein elektrisch isolierendes Element guter Wärmeleitfähigkeit in Form eines Plättchens (8) vorhanden ist, welches zwischen die leiterplattenseitige Fläche der Querplatte (16) und den zu befestigenden Halbleiter (3, 4) eingelegt und mit ihm zusammen durch die Federzunge (7) festgeklemmt werden kann,
- die Grundplatte (6) ferner an jedem Ende je eine abgewinkelte Fahne (12) aufweist, welche in je eine Bohrung (13) in der Leiterplatte (1) passt, womit die Grundplatte (6) genau positioniert werden kann.

2. Vorrichtung nach Patentanspruch 1, dadurch gekennzeichnet, dass
- die Querplatte (16) symmetrisch zum Steg (14) ausgebildet ist, sich also auf beide Seiten des Steges (14) gleich weit erstreckt
- die Federzungen (7) beidseitig des Steges und symmetrisch an der Grundplatte (6) des Federkörpers (15) vorhanden sind.

3. Vorrichtung nach Patentanspruch 2, dadurch gekennzeichnet, dass die Grundplatte (6) des Federkörpers (15) auf jeder Seite je eine Federzunge (7) trägt.

4. Vorrichtung nach Patentanspruch 2, dadurch gekennzeichnet, dass die Grundplatte (6) des Federkörpers (15) auf jeder Seite mehr als je eine Federzunge (7) trägt.

5. Vorrichtung nach Patentanspruch 1, dadurch gekennzeichnet, dass
- die Querplatte (16) asymmetrisch zum Steg (14) ausgebildet, auf der einen Seite also viel kürzer ist, als auf jener, die zur Aufnahme von Halbleitern (3, 4) vorgesehen ist,
- die Federzungen (7) nur einseitig an der Grundplatte (6) vorhanden sind,
- auf der jeder Federzunge (7) gegenüberliegenden Seite der Grundplatte (6) ein Federsporn (25) vorhanden ist, welcher eine solche Form aufweist, dass er an jener Stelle des Kühlkörpers (2) angreifen kann, wo der kürzere Teil der Querplatte (16) in den Steg (14) mündet.

6. Vorrichtung nach Patentanspruch 5, dadurch gekennzeichnet, dass die Grundplatte (6) eine Federzunge (7) und einen Federsporn (25) trägt.

7. Vorrichtung nach Patentanspruch 5, dadurch gekennzeichnet, dass die Grundplatte (6) mehr als eine Federzunge (7) und mehr als einen Federsporn (25) trägt.

8. Vorrichtung nach Patentanspruch 1, dadurch gekennzeichnet, dass der Steg (14) so hoch ausgebildet ist, dass zwischen der Leiterplatte (1) und den auf der Querplatte (16) festgehaltenen Halbleitern (3, 4) Raum bleibt für weitere auf der Leiterplatte (1) angebrachte Schaltelemente.

9. Vorrichtung nach Patentanspruch 1, dadurch gekennzeichnet, dass die von der Leiterplatte (1) abgewandte Fläche der Querplatte (16) eben ausgebildet ist.

10. Vorrichtung nach Patentanspruch 1, dadurch gekennzeichnet, dass die von der Leiterplatte (1) abgewandte Fläche der Querplatte (16) Rippenstruktur aufweist.

11. Vorrichtung nach Patentanspruch 1, dadurch gekennzeichnet, dass der Kühlkörper mindestens eine parallel zum Steg (14) verlaufende Sackbohrung (19) aufweist zur Aufnahme eines Thermofühlers (21).

## Claims

1. A device disposed on a circuit board (1) for fastening semiconductor control and circuit elements (hereinafter called semiconductors 3, 4) and for eliminating the heat dissipated therefrom, the device comprising a cooling member (2) on the one hand and a spring member (15) for pressing the semiconductor (3, 4) against the cooling member (2) on the other hand, the cooling member comprising a web (14) standing at right angles on the circuit board (1) and bearing a transverse plate (16) at right angles thereto, that is parallel to the circuit board (1), and the spring member (15) comprises a baseplate (6) and spring tongues (7) extending therefrom, **characterised in that**
- the web (14) of the cooling member (2) has threaded holes (11) for receiving screws (9) for fastening the web (14) to the circuit board (1),
- the baseplate (6) of the spring member (15) is inserted between the circuit board (1) and the web (14) and tightly secured with the said screws (9), to which end the baseplate (6) has holes (10) in line with the threaded holes (11),
- the spring tongues (7) are shaped and prestressed so as to press against the surface of the transverse plate (16) on the side near the circuit board,
- the surface of the transverse plate (16) on the side near the circuit board is flat and is given dimensions that the semiconductor (4) with the casing type TO 247 can be inserted without a projecting end between the spring tongue (7) and the said surface of the transverse plate (16),
- an electrically insulating element having good thermal conductivity and in the form of a thin layer (8) is present and is inserted between the said surface of the transverse plate (16) and the semiconductor (3, 4) for fastening and can be clamped thereto by the spring tongue, and
- the baseplate (6) at each end has a bent lug (12) which fits into a respective bore (13) in the circuit board (1) so that the baseplate (6) can be exactly positioned.

2. A device according to claim 1, **characterised in that**
- the transverse plate (16) is symmetrical relative to the web (14), that is it extends equally far on both sides of the web (14), and
- the spring tongues (7) are present on both sides of the web and are symmetrical with the baseplate (6) of the spring member (15).

3. A device according to claim 2, **characterised in that** the baseplate (6) of the spring member (15) bears a spring tongue (7) on each side.

4. A device according to claim 2, **characterised in that** the baseplate (6) of the spring member (15) bears more than one spring tongue (7) on each side.

5. A device according to claim 1, **characterised in that**
- the transverse plate (16) is asymmetrical relative to the web (14), that is it is much shorter on one side than on the side designed for receiving semiconductors (3, 4),
- the spring tongues (7) are present on the baseplate (6) on only one side, and
- a spring spike (25) is present on the side of the baseplate (6) opposite each spring tongue (7) and has a shape such that it can engage the cooling member (2) at the place where the shorter part of the transverse plate (16) merges into the web (14).

6. A device according to claim 5, **characterised in that** the baseplate (6) bears a spring tongue (7) and a spring spike (25).

7. A device according to claim 5, **characterised in that** the baseplate (6) bears more than one spring tongue (7) and more than one spring spike (25).

8. A device according to claim 1, **characterised in that** the web (14) is given a height such that space for additional circuit elements on the circuit board (1) is left between the circuit board (1) and the semiconductors (3, 4) fastened to the baseplate (16).

9. A device according to claim 1, **characterised in that** the surface of the transverse plate (16) remote from the circuit board (1) is flat.

10. A device according to claim 1, **characterised in that** the surface of the transverse plate (16) remote from the circuit board (1) has a finned structure.

11. A device according to claim 1, **characterised in that** the cooling member has at least one blind bore (19) parallel to the web (14) for receiving a heat sensor (21).

## Revendications

1. Dispositif, monté sur une plaquette (1), pour fixer des éléments de commande et de commutation à semi-conducteurs - appelés dans ce qui suit semi-conducteurs (3, 4) - et pour évacuer la chaleur dissipée de ceux-ci, comprenant d'une part un refroidisseur (2) et d'autre part un corps élastique (15) pour presser les semi-conducteurs (3, 4) contre le refroidisseur (2), étant précisé que le refroidisseur comporte une nervure (14) perpendiculaire à la plaquette (1), qui porte une plaque transversale (16) perpendiculaire à ladite nervure (14) et donc parallèle à la plaquette (1), tandis que le corps élastique (15) comporte une plaque de base (6) et des languettes élastiques (7) qui partent de celle-ci, caractérisé en ce que
- la nervure (14) du refroidisseur (2) porte des trous filetés (11) destinés à recevoir des vis (9) à l'aide desquelles la nervure (14) est fixée sur la plaquette (1),
- la plaque de base (6) du corps élastique (15) est placée entre la plaquette (1) et la nervure (14) et est serrée à l'aide des vis (9), et comporte à cet effet des trous (10) qui sont dans l'alignement des trous filetés (11),
- les languettes élastiques (7) sont formées et contraintes de manière à appuyer contre la surface de la plaque transversale (16) située côté plaquette,
- la surface de la plaque transversale (16) située côté plaquette a une forme plane et est dimensionnée pour qu'un semi-conducteur (4) puisse être placé avec le type de boîtier TO 247, sans dépasser, entre la surface de la plaque transversale (16) située côté plaquette et la languette élastique (7),
- il est prévu un élément isolant électriquement à bonne conductibilité thermique en forme de lamelle (8), qui peut être placé entre la surface de la plaque transversale (16) située côté plaquette et le semi-conducteur à fixer (3, 4) et être bloqué avec celui-ci par la languette élastique (7), et
- la plaque de base (6) comporte également, à chaque extrémité, une patte coudée (12) qui entre dans un perçage (13) de la plaquette (1), moyennant quoi la plaque de base (6) peut être positionnée avec précision.

2. Dispositif selon la revendication 1, caractérisé en ce que
- la plaque transversale (16) a une forme symétrique par rapport à la nervure (14) et s'étend donc sur la même distance des deux côtés de celle-ci, et
- les languettes élastiques (7) sont prévues de part et d'autre de la nervure et sont disposées symétriquement sur la plaque de base (6) du corps élastique (15).

3. Dispositif selon la revendication 2, caractérisé en ce que la plaque de base (6) du corps élastique (15) porte une languette élastique (7) de chaque côté.

4. Dispositif selon la revendication 2, caractérisé en ce que la plaque de base (6) du corps élastique (15) porte plus d'une languette élastique (7) de chaque côté.

5. Dispositif selon la revendication 1, caractérisé en ce que
- la plaque transversale (16) a une forme asymétrique par rapport à la nervure (14) et est donc beaucoup plus courte sur un côté que sur le côté destiné à recevoir des semi-conducteurs (3, 4),
- les languettes élastiques (7) ne sont prévues que sur un côté de la plaque de base (6), et
- il est prévu, sur le côté de la plaque de base (6) opposé à chaque languette élastique (7), une béquille élastique (25) qui a une forme telle qu'elle peut agir à l'endroit du refroidisseur (2) où la partie courte de la plaque transversale (16) débouche dans la nervure (14).

6. Dispositif selon la revendication 5, caractérisé en ce que la plaque de base (6) porte une languette élastique (7) et une béquille élastique (25).

7. Dispositif selon la revendication 5, caractérisé en ce que la plaque de base (6) porte plus d'une languette élastique (7) et plus d'une béquille élastique (25).

8. Dispositif selon la revendication 1, caractérisé en ce que la nervure (14) a une hauteur telle qu'il reste de la place, entre la plaquette (1) et les semi-conducteurs (3, 4) immobilisés sur la plaque transversale (16), pour d'autres éléments de commutation montés sur la plaquette (1).

9. Dispositif selon la revendication 1, caractérisé en ce que la surface de la plaque transversale (16) opposée à la plaquette (1) a une forme plane.

10. Dispositif selon la revendication 1, caractérisé en ce que la surface de la plaque transversale (16) opposée à la plaquette (1) présente une structure nervurée.

11. Dispositif selon la revendication 1, caractérisé en ce que le refroidisseur présente au moins un perçage borgne (19) parallèle à la nervure (14) pour recevoir une sonde de température (21).
